# EUROPEAN PATENT SPECIFICATION

(11) **EP 1 450 455 B1**
(45) Date of publication and mention of the grant of the patent: **25.01.2006**
(21) Application number: 03300199.1
(22) Date of filing: 06.11.2003
(51) Int. Cl.: H01S 5/0683, H01S 5/042, G01R 31/28, G11B 7/12

(54) **Method and electronic circuit for controlling of a supply voltage of a laser diode**
Verfahren und elektronischer Schaltkreis zur Steuerung der Versorgungsspannung einer Laserdiode
Méthode et circuit électronique pour commander la tension d'alimentation d'une diode laser

(30) Priority: 21.01.2003 EP 03001169
(43) Date of publication of application: 25.08.2004
(73) Proprietor: Thomson Licensing, 92100 Boulogne Billancourt (FR)
(72) Inventor: Vogel, Patrick, 78052 Villingen-Schwenningen (DE); Lehr, Steffen, 78050 Villingen-Schwenningen (DE)
(74) Representative: Rossmanith, Manfred

(56) References cited:
- EP-A- 1 111 745
- US-B1- 6 363 044

## Description

### Field of the invention

The present invention generally relates to the field of controlling of light sources, and more particularly to controlling of a laser diode of an optical reader and/or recorder, such as CD or DVD players and/or recorders.

### Background

Typically a laser diode is arranged in a PNP type circuit configuration or, alternatively, in an NPN type circuit configuration. The control of the supply voltage of the laser diode needs to be adapted to the type of circuit configuration which is used, otherwise the lifetime of the laser diode is reduced or the laser diode is even destroyed when the control of the power supply is initialized.

US Patent number 6,363,044 B1 shows a photo diode detection circuit which is used to automatically identify a type of photo diode circuit connected to it. Once the type of photo diode circuit has been identified by applying a current to it and evaluating a voltage occurring at an input of the detection circuit, the photo detection circuit adapts itself to it, e.g. a reverse biasing voltage is or is not applied to the photo diode of the photo diode circuit. The result is a photo diode detection circuit which uses a forward or a reversed biased photo diode. The photo diode detection circuit is now in a state to measure light falling on the photo diode. The detection circuit is used for monitoring the light intensity of a light source and for a controlling circuit which enables to regulate the intensity of the light source. It is a disadvantage of this prior art controlling circuit that it does not automatically adapt to the circuit configuration in which the light source is arranged.

### Summary of the invention

It is an object of the invention to find a solution for a control circuit and method which automatically adapts to the circuit configuration in which a laser diode is arranged.

A solution to the above described problem is provided by applying the features laid down in the respective independent claims. Preferred embodiments of the invention are given in the dependent claims.

The invention enables an effective protection of a light source, such as a laser diode, against application of a wrong supply voltage. It is a particular advantage of the present invention that this accomplished without a need for an extra control pin and without inputting of control information indicating the kind of circuit configuration of the laser diode. Rather the present invention enables to automatically detect the circuit configuration of the laser diode and to initialize the control of the power supply for the laser diode correspondingly.

The present invention is advantageously employed for optical readers and/or recorders such as CD and/or DVD readers and/or recorders.

### Brief description of the drawings

In the following preferred embodiments of the invention will be described in greater detail by making reference to the drawings in which:
- Figure 1: shows a block diagram of an embodiment of an electronic circuit of the invention,
- Figure 2: shows a detailed view on the module of figure 1 generating the OUTPOL signal,
- Figure 3: is an alternative embodiment of the circuit of figure 2,
- Figure 4: is illustrative of a signal diagram when the output stage is of the PNP type,
- Figure 5: is illustrative of a signal diagram when the output stage is of the NPN type,
- Figure 6: shows an alternative embodiment of the circuit of figure 1 having an additional detector for the polarity of the measurement signal,
- Figure 7: to figure 10 are illustrative of signal diagrams of the preferred embodiment of figure 6

### Detailed description

Figure 1 shows a control circuit 100 having a comparator 102. The comparator 102 has input switches S11, S12, S13 and S14 which determine the output polarity of the comparator 102. The input voltage at pin IN of the comparator 102 is compared with an adjustable reference voltage Vrefl.

Further control circuit 100 has an active off circuitry 104, which comprises two current sources Iu Id as well as switches S31 and S32.

A safety block 106 is coupled to the control circuit 100. The safety block 106 decides when the laser control switches from the active off phase into the start up phase. The safety block 106 generates an ENABLE signal when the command ON is applied and if the start up condition (external capacitors are de-charged) are fulfilled.

Further there is a safety block 108 which is coupled to the control circuit 100. Safety block 108 serves to determine whether the laser diode which is controlled by the control circuit 100 is in a PNP type or an NPN type circuit configuration. Preferred implementations of safety block 108 are illustrated in figures 2 and 3.

A PNP type circuit configuration 110 having a laser diode 112 or alternatively an NPN type circuit configuration 114 comprising laser diode 116 is connected to the output OUT of control circuit 100. The PNP type circuit configuration 110 is a driver circuit for the laser diode 112 using an PNP transistor type. Likewise the NPN type circuit configuration 114 is a driver circuit for laser diode 116 using an NPN transistor type.

A measurement photo diode 118 is connected to the input IN of the control circuit 100. The photo diode 118 measures the light emission of the laser diode 112 or laser diode 116, respectively. This way a feedback signal is provided to control circuit 100 which forms the basis for controlling the supply voltage for laser diode 112, or laser diode 116.

The voltage control of the control circuit 100 is adapted by the OUTPOL signal delivered by the safety block 108 depending whether PNP type circuit configuration 110 or NPN type circuit configuration 114 is connected to the output OUT of control circuit 100. In particular the polarity of the comparator 102 and also the active OFF circuitry 104 is adapted accordingly depending on the OUTPOL signal. The operation of the control circuit 100 has several operation modes:

### - active OFF

The external capacitance of the PNP type circuit configuration 110 or the NPN type circuit configuration 114 is de-charged, so that the laser diode 112 or 116, respectively is OFF. This is a safety requirement in order to avoid destruction of the expensive laser diodes 112 or 116.

### - active ON

The laser control is switched off when the start up phase is entered. During the start up phase safety functions are checked and the external capacitors are charged.

### - control phase

When all safety checks have been fulfilled the control circuit 100 enters the control phase. The laser diode light emission is regulated based on the reference voltage Vrefl.

Figure 2 is illustrative of an implementation of the safety block 108. Figure 3 is illustrative of an alternative implementation of the safety block 108 which is preferred to the implementation of figure 2. The INIT block generates a pulse of about 100 nanoseconds pulse length when the supply voltage has reached its nominal value. With this pulse the OUTPOL signal is set to a default setting. For example the default setting is OUTPOL = 1 which means that the PNP type circuit configuration 110 (cf. figure 1) is the default circuit configuration.

Alternatively the NPN type circuit configuration 114 can be chosen as a default configuration.

Figure 4 is illustrative of the initialization of the control of the supply voltage depending on the type of circuit configuration. In the embodiment of figures 4 and 5, it is assumed that the default setting is OUTPOL = 1, which means that PNP type circuit configuration 110 is the default circuit configuration.

Figure 4 shows the signal diagram if the circuit configuration of the laser diode is indeed of the PNP type circuit configuration 110.

During the active OFF phase the supply voltage at the output OUT is gradually increased towards the reference voltage Vrefpnp of the PNP type circuit configuration 110 (cf. Fig. 1). At the same time the measurement signal applied at the input IN is monitored. As the measurement signal applied at the input IN does not show a peak this means that the assumption that the laser diode is in the PNP type circuit configuration 110 is correct and that the polarity of the signal OUTPOL does not need to be changed from the default setting. After the active OFF and the start up phase, the control operation for controlling the supply voltage starts.

Figure 5 shows a corresponding signal diagram when the output circuit configuration is not the default PNP type circuit configuration but an NPN type circuit configuration. Again the supply voltage at the output OUT of the control circuit is gradually increased towards the reference voltage VREFPNP of the PNP type circuit configuration 110 as the PNP type circuit configuration is the assumed configuration. As the laser diode is in fact arranged in an NPN type circuit configuration application of the gradually increasing supply voltage results in the emission of light from the laser diode and thus in a peak 120 of the measurement signal applied at the input IN.

In response to the peak 120 the polarity of the OUTPOL signal is changed from 1 to 0 and the direction of change of the supply voltage signal at the output OUT is likewise changed into the direction of the voltage reference Vrefnpn of NPN type circuit configuration 114.

Figure 6 shows a block diagram of an extended embodiment based on the embodiment of figure 1. In the embodiment of figure 6 there is photo diode detection circuit 122 between the input IN and the input of control circuit 100. Preferably photo diode detection circuit 122 is designed in accordance with US patent number 6,363,044B1, which is incorporated herein by reference in its entirety.

Due to the photo diode detection circuit 122 it is possible to either use photo diode 118 or reverse biased photo diode 124. In either case the photo diode detection circuit 122 will deliver the same signal INCOMP for inputting into the comparator 102 of the control circuit 100 (cf. figure 1).

As apparent from the signal diagrams of figures 7 to 10, the operation of the control circuit 100 is the same irrespective of whether photo diode 118 or photo diode 124 is used. Figure 7 shows the signal diagram where the laser diode is arranged in the default PNP type circuit configuration and diode 118 is used. Figure 8 shows the situation where diode 124 is used. In this instance the polarity of the It4POL signal is changed, such that switch S5 of photo diode detection circuit 122 (cf. figure 6) is switched from its '1' to its '0' position.

Figures 9 and 10 show the corresponding signal diagrams for a laser diode being arrange in an NPN type circuit configuration.

## Claims

1. A method for initialising a control of a supply voltage of a light source, such as a laser diode, the light source being arranged in a first circuit configuration having an associated first reference voltage level or the light source being arranged in an alternative second circuit configuration having an associated alternative second reference voltage level, the method comprising the steps of:
- gradually changing the supply voltage into the direction of the first reference voltage,
- measuring a light emission of the light source while gradually changing the supply voltage,
- if no light emission is measured: starting the control of the supply voltage of the light source after the first reference voltage has been reached,
- if a light emission is measured: gradually changing the supply voltage into the direction of the second reference voltage and starting the control of the supply voltage of the light source after the second reference voltage has been reached.

2. The method of claim 1, the first circuit configuration being an PNP type circuit configuration and the second circuit configuration being an NPN type circuit configuration.

3. The method of claim 1 or 2, whereby the light emission of the light source is measured by means of a photodiode.

4. The method of claim 1,2 or 3, further comprising detecting of a polarity of the measurement of the light emission of the laser diode.

5. An electronic circuit for controlling a supply voltage of a light source, such as a laser diode (112, 116), the light source being arranged in a first circuit configuration (110) having an associated first reference voltage level, or the light source being arranged in alternative second circuit configuration (114) having an associated alternative second reference voltage level, the electronic circuit comprising:
- means (100) for gradually changing the supply voltage into the direction of the first reference voltage for initialising the control of the supply voltage,
- means (118; 124) for detecting of a light emission of the laser diode,
- means (100) for gradually changing the supply voltage into the direction of the second reference voltage, if a light emission of the laser diode is detected while the supply voltage is gradually changed into the direction of the first reference voltage.

6. The electronic circuit of claim 5, whereby the first circuit configuration is of an PNP type and the second circuit configuration is of an NPN type.

7. The electronic circuit of claims 5 or 6, the means for detecting a light emission comprising a laser diode.

8. The electronic circuit of claims 5, 6 or 7, further comprising means (122) for detecting of a polarity of a measurement signal provided by the means for detecting of a light emission.

9. An optical reader and/or recorder comprising a laser diode and an electronic circuit for controlling of a supply voltage of the laser diode in accordance with any one of the preceding claims 5 to 8.

## Patentansprüche

1. Verfahren zum Initialisieren einer Steuerung einer Versorgungsspannung einer Lichtquelle wie etwa einer Laserdiode, wobei die Lichtquelle in einer ersten Schaltungskonfiguration mit einem assoziierten ersten Referenzspannungspegel oder die Lichtquelle in einer alternativen zweiten Schaltungskonfiguration mit einem assoziierten alternativen zweiten Referenzspannungspegel angeordnet ist, wobei das Verfahren die folgenden Schritte umfaßt:
- allmähliches Ändern der Versorgungsspannung in Richtung der ersten Referenzspannung,
- Messen einer Lichtemission der Lichtquelle, während die Versorgungsspannung allmählich geändert wird,
- falls keine Lichtemission gemessen wird: Beginnen der Steuerung der Versorgungsspannung der Lichtquelle, nachdem die erste Referenzspannung erreicht worden ist,
- falls eine Lichtemission gemessen wird: allmähliches Ändern der Versorgungsspannung in der Richtung der zweiten Referenzspannung und Beginnen der Steuerung der Versorgungsspannung der Lichtquelle, nachdem die zweite Referenzspannung erreicht worden ist.

2. Verfahren nach Anspruch 1, wobei die erste Schaltungskonfiguration eine PNP-Schaltungskonfiguration und die zweite Schaltungskonfiguration eine NPN-Schaltungskonfiguration ist.

3. Verfahren nach Anspruch 1 oder 2, wobei die Lichtemission der Lichtquelle mit Hilfe einer Fotodiode gemessen wird.

4. Verfahren nach Anspruch 1, 2 oder 3, weiterhin mit dem Detektieren einer Polarität der Messung der Lichtemission der Laserdiode.

5. Elektronikschaltung zum Steuern einer Versorgungsspannung einer Lichtquelle wie etwa einer Laserdiode (112, 116), wobei die Lichtquelle in einer ersten Schaltungskonfiguration (110) mit einem assoziierten ersten Referenzspannungspegel oder die Lichtquelle in einer alternativen zweiten Schaltungskonfiguration (114) mit einem assoziierten alternativen zweiten Referenzspannungspegel angeordnet ist, wobei die Elektronikschaltung folgendes umfaßt:
- Mittel (100) zum allmählichen Ändern der Versorgungsspannung in Richtung der ersten Referenzspannung zum Initialisieren der Steuerung der Versorgungsspannung,
- Mittel (118; 124) zum Detektieren einer Lichtemission der Laserdiode,
- Mittel (100) zum allmählichen Ändern der Versorgungsspannung in Richtung der zweiten Referenzspannung, wenn eine Lichtemission der Laserdiode detektiert wird, während die Versorgungsspannung allmählich in Richtung der ersten Referenzspannung geändert wird.

6. Elektronikschaltung nach Anspruch 5, wobei die erste Schaltungskonfiguration vom PNP-Typ und die zweite Schaltungskonfiguration vom NPN-Typ ist.

7. Elektronikschaltung nach den Ansprüchen 5 oder 6, wobei die Mittel zum Detektieren einer Lichtemission eine Laserdiode umfassen.

8. Elektronikschaltung nach den Ansprüchen 5, 6 oder 7, weiterhin mit Mitteln (122) zum Detektieren einer Polarität eines von den Mitteln zum Detektieren einer Lichtemission gelieferten Meßsignals.

9. Optisches Lesegerät und/oder Aufzeichnungsgerät mit einer Laserdiode und einer Elektronikschaltung zum Steuern einer Versorgungsspannung der Laserdiode gemäß einem beliebigen der vorausgegangenen Ansprüche 5 bis 8.

## Revendications

1. Méthode d'initialisation d'une commande d'une tension d'alimentation d'une source lumineuse, telle qu'une diode laser, la source lumineuse étant disposée dans une première configuration de circuit ayant un premier niveau de tension de référence associé ou la source lumineuse étant disposée dans une seconde configuration de circuit ayant un second niveau de tension de référence associé, la méthode comprenant les étapes suivantes :
- changement progressif de la tension d'alimentation dans la direction de la première tension de référence,
- mesure d'une émission de lumière de la source lumineuse tout en changeant progressivement la tension d'alimentation,
- si aucune émission de lumière n'est mesurée : exécution de la commande de tension d'alimentation de la source lumineuse une fois la première tension de référence atteinte,
- si une émission de lumière est mesurée : changement progressif de la tension d'alimentation dans la direction de la seconde tension de référence et exécution de la commande de tension d'alimentation de la source lumineuse une fois la seconde tension de référence atteinte.

2. La méthode de la revendication 1, la première configuration de circuit étant une configuration de circuit de type PNP et la seconde configuration de circuit étant une configuration de circuit de type NPN.

3. La méthode de la revendication 1 ou 2, par laquelle l'émission de lumière est mesurée au moyen d'une photodiode.

4. La méthode de la revendication 1,2 ou 3, permettant en outre de détecter une polarité de la mesure de l'émission de lumière de la diode laser.

5. Un circuit électronique de commande d'une tension d'alimentation d'une source lumineuse, telle qu'une diode laser (112,116), la source lumineuse étant disposée dans une première configuration de circuit (110) ayant un premier niveau de tension de référence associé ou la source lumineuse étant disposée dans une seconde configuration de circuit (114) ayant un second niveau de tension de référence associé, le circuit électronique comprenant :
- un moyen (100) de changement progressif de la tension d'alimentation dans la direction de la première tension de référence pour initialiser la commande de tension d'alimentation,
- un moyen (118 ; 124) de détection d'une émission de lumière de la diode laser,
- un moyen (100) de changement progressif de la tension d'alimentation dans la direction de la seconde tension de référence, si une émission de lumière de la diode laser est détectée pendant que la tension d'alimentation est progressivement changée dans la direction de la première tension de référence.

6. Le circuit électronique de la revendication 5, dans lequel la première configuration de circuit est de type PNP et la seconde configuration de circuit est de type NPN.

7. Le circuit électronique des revendications 5 ou 6, le moyen de détection d'une émission de lumière comprenant une diode laser.

8. Le circuit électronique des revendications 5, 6 ou 7, comprenant, en outre, un moyen (122) de détection d'une polarité d'un signal de mesure fourni par le moyen de détection d'une émission de lumière.

9. Un lecteur et/ou enregistreur optique comprenant une diode laser et un circuit électronique de commande d'une tension d'alimentation de la diode laser selon l'une des revendications 5 à 8 précédentes.
